# EUROPÄISCHE PATENTSCHRIFT

(11) **EP 3 364 453 B1**
(45) Veröffentlichungstag und Bekanntmachung des Hinweises auf die Patenterteilung: **29.09.2021**
(21) Anmeldenummer: 18152767.2
(22) Anmeldetag: 22.01.2018
(51) Int. Cl.: H01L 23/473

(54) **KÜHLDOSE, KÜHLVORRICHTUNG SOWIE VERFAHREN ZUR HERSTELLUNG EINER KÜHLDOSE**
COOLING BOX, COOLING DEVICE AND METHOD FOR PRODUCING A COOLING BOX
BOÎTE DE REFROIDISSEMENT, DISPOSITIF DE REFROIDISSEMENT AINSI QUE PROCÉDÉ DE FABRICATION D'UNE BOÎTE DE REFROIDISSEMENT

(30) Priorität: 21.02.2017 DE 102017202756
(43) Veröffentlichungstag der Anmeldung: 22.08.2018
(73) Patentinhaber: Siemens Energy Global GmbH & Co. KG, 81739 München (DE)
(72) Erfinder: Danov, Vladimir, 91056 Erlangen (DE); Kautz, Martin, 91056 Erlangen (DE); Macher, Andreas, 01157 Dresden (DE)

(56) Entgegenhaltungen:
- DE-A1- 2 640 000
- DE-A1- 4 017 749
- DE-A1- 4 202 024
- DE-A1- 19 600 164

## Beschreibung

Die Erfindung betrifft eine Kühldose zur Kühlung elektrischer Bauelemente. Weiterhin betrifft die Erfindung eine Kühlvorrichtung mit einer Mehrzahl von Kühldosen sowie ein Verfahren zur Herstellung einer erfindungsgemäßen Kühldose.

Elektrische und/oder elektronische Bauelemente eines Leistungsschalters werden typischerweise aktiv gekühlt um die beim Betrieb des Leistungsschalters anfallende Wärme (auch Verlustwärme oder Abwärme genannt) abzuführen.

Die aktive Kühlung des Leistungsschalters kann mittels einer Kühldose erfolgen. Hierzu wird die Kühldose, die zur Kühlung elektrischer und/oder elektronischer Bauteile des Leistungsschalters vorgesehen ist, mit einem Kühlfluid durchströmt. Das Kühlfluid nimmt die Verlustwärme auf und gibt diese an die Umgebung des Leistungsschalters ab. Die Kühldose ist hierzu an das durch sie strömende Kühlfluid angepasst. Soll ein weiteres Kühlfluid verwendet werden, so ist typischerweise die Funktion der Kühldose eingeschränkt oder nicht mehr sichergestellt.

Ein Austausch des Kühlfluids ist beispielsweise dann erforderlich, wenn für eine dezentrale Anlage mit einem Leistungsschalter ein gemeinsames Kühlfluid für einen Transformator und dem Leistungsschalter verwendet werden soll.

Typischerweise wird eine Mehrzahl von Kühldosen zur Kühlung der elektrischen und/oder elektronischen Bauelemente des Leistungsschalters verwendet. Hierbei werden die Bauelemente zwischen den Kühldosen angeordnet. Mit anderen Worten werden die elektrischen und/oder elektronischen Bauelemente eines Leistungsschalters, typischerweise Thyristoren, einseitig oder beidseitig von Kühldosen gekühlt.

Nachteilig am Stand der Technik ist, dass für jedes Kühlfluid eine eigens dafür angepasste Kühldose erforderlich ist. Beispielsweise können hochviskose Kühlfluide, insbesondere Öle, wegen der für Wasser auslegungsbedingt kleinen Kanalquerschnitte nicht als Ersatz für Wasser herangezogen werden können. Das ist deshalb der Fall, da dann ihre Strömung durch die Kühldose typischerweise nicht mehr turbulent sondern laminar wäre, sodass sich ein verringerter Wärmeübergang zwischen der Kühldose und den zu kühlenden elektrischen und/oder elektronischen Bauelementen ausbildet. Weiterhin wird dadurch der Druckverlust vergrößert.

Die DE 26 40 000 A betrifft eine Kühldose für eine Flüssigkeitskühlung von Leistungshalbleiterbauelementen. Die Kühldose ist aus zwei Kühldosenhälften gebildet. Zwischen den Kühldosenhälften, das heißt im Innenraum der Kühldose, sind Zapfen angeordnet.

Die DE 42 02 024 A betrifft eine Isolierkühldose zum Abführen der Verlustwärme von Halbleiterbauelementen. Die Isolierkühldose weist zwei halbschalenförmige Kühlkörper auf. Weiterhin weist die Isolierkühldose Kühlnoppen auf.

Die DE 196 00 164 A1 betrifft einen Kühlkörper bestehend aus einem oberen und unteren Teil. Der Innenraum weist wiederum Zapfen auf.

Die DE 40 17 749 A1 betrifft einen Flüssigkeitskühlkörper zur Kühlung eines elektrischen Bauelements. Senkrecht zu zwei Böden (Kühlkörperhälften) des Flüssigkeitskühlkörpers sind Zapfen angeordnet, die von Boden zu Boden reichen und mit den Böden stoffschlüssig verbunden sind.

Der vorliegenden Erfindung liegt die Aufgabe zugrunde eine verbesserte Kühldose bereitzustellen.

Die Aufgabe wird durch eine Kühldose mit den Merkmalen des unabhängigen Patentanspruches 1, durch eine Kühlvorrichtung mit den Merkmalen des unabhängigen Patentanspruches 8 sowie durch ein Verfahren zur Herstellung einer Kühldose mit den Merkmalen des unabhängigen Patentanspruches 11 gelöst. In den abhängigen Patentansprüchen sind vorteilhafte Ausgestaltungen und Weiterbildungen der Erfindung angegeben.

Die erfindungsgemäße Kühldose zur Kühlung elektrischer Bauelemente weist zwei verbundene Halbschalen auf. Erfindungsgemäß umfasst die Kühldose eine Mehrzahl von Stützelementen, wobei die Stützelemente innerhalb eines zwischen den zwei Halbschalen ausgebildeten Volumens zur mechanischen Stützung der Halbschalen angeordnet sind. Erfindungsgemäß sind die Stützelemente Y-förmig ausgebildet.

Im Sinne der vorliegenden Erfindung werden elektronische Bauelemente als elektrische Bauelemente angesehen.

Vorteilhafterweise wird durch die erfindungsgemäß vorgesehenen Stützelemente die mechanische Festigkeit der erfindungsgemäßen Kühldose gegenüber aus dem Stand der Technik bekannten Kühldosen erhöht. Dadurch kann eine höhere Verspannung der Kühldosen gegeneinander erreicht werden. Ein weiterer Vorteil der erfindungsgemäß vorgesehenen Stützelemente ist, dass diese wie Rippen oder Kühlrippen wirken und somit zu einer verbesserten Wärmeübertragung zwischen der Kühldose und den zu kühlenden elektrischen Bauelementen führen. Das ist deshalb der Fall, da die durch die Stützelemente ausgebildete wärmeübertragende Fläche vergrößert wird.

Ein weiterer besonderer Vorteil der erfindungsgemäß vorgesehenen Stützelemente ist, dass durch diese eine laminare Strömung eines Kühlfluids durch die Kühldose verhindert wird. Dadurch wird die Wärmeübertragung aufgrund einer erhöhten turbulenten Strömung des Kühlfluids verbessert. Insbesondere wird eine turbulente Strömung des Kühlfluids auch bei sehr niedrigen Reynolds-Zahlen Re, beispielsweise Re < 2300, ermöglicht.

Mit anderen Worten ermöglichen die erfindungsgemäß vorgesehenen Stützelemente eine mechanische sowie thermische Verbesserung der Kühldose, wobei diese Vorteile synergetisch zusammenwirken.

Weiterhin weist die erfindungsgemäße Kühldose eine vergleichsweise hohe Flexibilität bezüglich der Auswahl des Kühlfluids auf. Das ist deshalb der Fall, da durch eine einfache geometrische Änderung, beispielsweise über eine veränderte räumliche Anordnung der Stützelemente, die Kühldose und deren Strömungseigenschaften an das verwendete Kühlfluid anpassbar ist.

Insgesamt wird erfindungsgemäß eine verbesserte Kühldose bereitgestellt, die einen effizienten Aufbau und geringe Fertigungskosten aufweist, eine turbulente Strömung eines Kühlfluids auch bei niedrigen Reynolds-Zahlen ermöglicht sowie eine erhöhte mechanische Stabilität aufweist, sodass Druckkräfte bei einer Verspannung besser aufgenommen und kompensiert werden können.

Weiterhin wird eine Vergleichmäßigung des Strömungsfeldes des verwendeten Kühlfluids ermöglicht.

Ferner wird der Wärmeübergang verbessert, da die Wärmeübertragende Fläche vergrößert und eine homogen Verteilung des Kühlfluids über ihren Querschnitt ermöglicht wird.

Insbesondere sind die Stützelemente im Querschnitt Y-förmig ausgebildet. Vorteilhafterweise wird durch die Y-förmige Struktur der Stützelemente eine verbesserte Verteilung des Kühlfluids innerhalb der Kühldose ermöglicht. Dadurch wird die Wärmeübertragung der Kühldose verbessert. Zudem weisen Y-förmige Stützelemente eine erhöhte mechanische Stabilität auf, sodass gleichzeitig die mechanische Stabilität der Kühldose verbessert wird.

In einer vorteilhaften Weiterbildung der Erfindung sind die Halbschalen als tiefgezogene Bleche ausgebildet.

Dadurch kann vorteilhafterweise eine kostengünstige Kühldose bereitgestellt werden.

Gemäß einer vorteilhaften Ausgestaltung der Erfindung sind die zwei Halbschalen wenigstens teilweise stoffschlüssig verbunden.

Vorteilhafterweise wird dadurch eine fluiddichte Verbindung der zwei Halbschalen ermöglicht. Zudem kann die stoffschlüssige Verbindung der zwei Halbschalen mit vorteilhaften Verfahren, insbesondere Schweißverfahren und/oder Lötverfahren, erfolgen.

Insbesondere bei Halbschalen, die als tiefgezogene Bleche ausgebildet sind, ist eine stoffschlüssige Verbindung von Vorteil.

In einer vorteilhaften Weiterbildung der Erfindung bildet die Anordnung der Stützelemente ein regelmäßiges Gitter, das heißt ein strukturiertes Gitter, aus.

Dadurch kann vorteilhafterweise eine homogene Verteilung des Kühlfluids über den Querschnitt der Kühldose erreicht werden.

Gemäß einer vorteilhaften Weiterbildung der Erfindung ist jedes Stützelement wenigstens teilweise stoffschlüssig mit den zwei Halbschalen verbunden.

Mit anderen Worten können die Stützelemente an den zwei Halbschalen beispielsweise durch ein Schweißverfahren, ein Lötverfahren, ein Klebeverfahren und/oder mittels Haltegitter, angeordnet oder räumlich fixiert werden. Dadurch ergibt sich eine besonders vorteilhafte mechanische Stützung, sodass ein Kollabieren der zwei Halbschalen, insbesondere der zwei tiefgezogenen Bleche, bei einer Verspannung einer Mehrzahl von Kühldosen vermieden wird.

Mit anderen Worten können kostengünstige und mechanisch nicht besonders stabile tiefgezogene Bleche zur Ausbildung der Kühldose verwendet werden. Die mechanische Stabilität der Kühldose wird durch die erfindungsgemäß vorgesehenen Stützelemente sichergestellt. Weiterhin ergibt sich der Vorteil, dass die Stützelemente zu einer verbesserten Durchströmung der Kühldose mit einem Kühlfluid und zu einer Vergrößerung der wärmeübertragenden Fläche führen, sodass die wärmeübertragenden Eigenschaften der Kühldose verbessert werden. Die erfindungsgemäß vorgesehenen Stützelemente weisen folglich zwei Vorteile auf. Sie stellen die mechanische Stabilität der Kühldose sicher und verbessern ihre in Bezug auf die Kühlung elektrischer Bauelemente thermischen Eigenschaften.

In einer vorteilhaften Weiterbildung der Erfindung weist die Kühldose wenigstens zwei Öffnungen zum Einleiten und/oder Ausleiten eines Kühlfluids auf.

Dadurch wird vorteilhafterweise die Durchströmung der Kühldose mit einem Kühlfluid sichergestellt.

Die erfindungsgemäße Kühlvorrichtung zur Kühlung elektrischer Bauelemente ist dadurch gekennzeichnet, dass diese eine Mehrzahl von Kühldosen gemäß der vorliegenden Erfindung oder einer ihrer Ausgestaltungen aufweist, wobei die Kühldosen gestapelt angeordnet sind.

Es ergeben sich zur bereits genannten erfindungsgemäßen Kühldose gleichartige und gleichwertige Vorteile der erfindungsgemäßen Kühlvorrichtung.

Gemäß einer vorteilhaften Ausgestaltung der Kühlvorrichtung ist zwischen zwei benachbarten Kühldosen wenigstens ein zu kühlendes elektrisches Bauelement, insbesondere ein Thyristor und/oder ein Bipolartransistor mit isolierter Gate-Elektrode (englisch Insulated-Gate Bipolar Transistor; kurz IGBT), angeordnet.

Dadurch wird vorteilhafterweise eine Kühlvorrichtung bereitgestellt, die eine besonders vorteilhafte Kühlung elektrischer Bauelemente, insbesondere eines Thyristors und/oder eines IGBT ermöglicht. Die genannte Kühlvorrichtung ist insbesondere für einen Leistungsschalter von Vorteil.

Besonders bevorzugt sind die gestapelten Kühldosen zusammen mit dem wenigstens einen elektrischen Bauelement mechanisch gegeneinander verspannt.

Vorteilhafterweise wird die mechanische Verspannung der Kühldosen mit dem elektrischen Bauelement erst durch die erfindungsgemäßen Stützelemente der erfindungsgemäßen Kühldose ermöglicht. Dadurch können die mechanischen Anforderungen an die Schalung der Kühldosen, die durch die zwei Halbschalen ausgebildet wird, reduziert werden, da die Verspannungskräfte hauptsächlich durch die erfindungsgemäß vorgesehenen Stützelemente aufgenommen werden und somit die Kühldose im verspannten Stapel stabilisiert wird.

Bei dem erfindungsgemäßen Verfahren zur Herstellung einer Kühldose gemäß der vorliegenden Erfindung oder einer ihrer Ausgestaltungen werden zwei Halbschalen zur Ausbildung eines Volumens wenigstens teilweise miteinander verbunden. Bevorzugt sind die zwei Halbschalen hierbei als tiefgezogene Bleche ausgebildet. Erfindungsgemäß wird vor oder nach dem Verbinden der zwei Halbschalen eine Mehrzahl von Stützelementen zur mechanischen Stützung der zwei Halbschalen innerhalb eines Volumens zwischen den zwei Halbschalen angeordnet. Erfindungsgemäß werden Y-förmige Stützelemente verwendet.

Es ergeben sich zur bereits genannten erfindungsgemäßen Kühldose oder zur bereits genannten erfindungsgemäßen Kühlvorrichtung gleichartige und gleichwertige Vorteile des erfindungsgemäßen Verfahrens.

Insbesondere ist es von Vorteil wenn die zwei Halbschalen stoffschlüssig, beispielsweise mittels eines Schweißverfahrens und/oder eines Lötverfahrens, verbunden werden. Dies ist insbesondere bei zwei Halbschalen von Vorteil, die als tiefgezogene Bleche ausgebildet sind. Die zwei Halbschalen können aus Aluminium gebildet sein oder Aluminium umfassen.

Gemäß einer vorteilhaften Ausgestaltung des Verfahrens wird jedes Stützelement wenigstens teilweise mit den zwei Halbschalen stoffschlüssig, insbesondere mittels eines Schweißverfahrens und/oder eines Lötverfahrens, verbunden.

Dadurch ergibt sich eine mechanisch besonders stabile Kühldose.

Hierbei ist es besonders von Vorteil, wenn gesägte und/oder gefräste Stützelemente verwendet werden.

Das ist deshalb von Vorteil, da gesägte und/oder gefräste Stützelemente eine ausreichend hohe Genauigkeit bezüglich ihrer Fertigungsmaße aufweisen, sodass eine besonders vorteilhafte Durchströmung der Kühldose mit dem Kühlfluid erreicht wird.

Weiterhin ist es von Vorteil die Stützelemente mittels eines generativen Fertigungsverfahrens beziehungsweise mittels Additiver Fertigung (englisch: Additive Manufacturing) herzustellen. Dadurch können die Y-förmigen Stützelemente mit einer komplexen Struktur vorteilhaft hergestellt beziehungsweise gefertigt werden.

Weitere Vorteile, Merkmale und Einzelheiten der Erfindung ergeben sich aus den folgenden beschriebenen Ausführungsbeispielen sowie anhand der Zeichnungen. Dabei zeigen schematisiert:
- Figur 1: eine Kühldose in einer Draufsicht gemäß einer Aus-gestaltung der vorliegenden Erfindung;
- Figur 2: die Kühldose aus Figur 1 in einer Seitenansicht;
- Figur 3: eine weitere nicht zur Erfindung zughörige Kühldose in einer Draufsicht; und
- Figur 4: einen vergrößerten Ausschnitt der Kühldose aus Figur 3.

Gleichartig, gleichwertige oder gleichwirkende Elemente können in den Figuren mit denselben Bezugszeichen versehen sein.

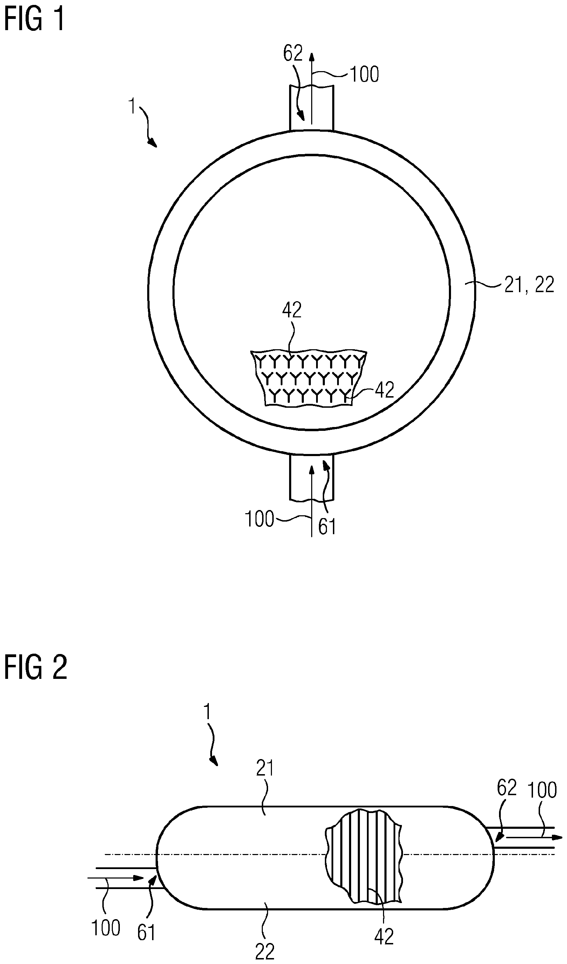

Figur 1 zeigt die Kühldose 1 in einer Draufsicht. Die Kühldose 1 umfasst zwei miteinander verbundene Halbschalen 21, 22. Hierbei sind die Halbschalen 21, 22, bis auf Öffnungen zum Einleiten und/oder Ausleiten eines Kühlfluids, fluiddicht miteinander verbunden. Mit anderen Worten sind die zwei Halbschalen 21, 22 wenigstens teilweise fluiddicht miteinander verbunden.

Die Kühldose 1 weist eine erste Öffnung 61 zum Einleiten eines Kühlfluids und eine zweite Öffnung 62 zum Ausleiten des Kühlfluids auf. Die Durchströmung der Kühldose 1 mit dem Kühlfluid ist durch die Pfeile 100 gekennzeichnet.

Weiterhin zeigt Figur 1 eine sinnbildliche Öffnung der Kühldose 1, in welcher eine Mehrzahl von Stützelementen 42, die Y-förmig ausgebildet sind, gezeigt ist. Aus Gründen der Übersicht sind nur zwei der Stützelemente 42 mit dem Bezugszeichen 42 gekennzeichnet. Die Stützelemente 42 sind gemäß eines strukturierten Gitters innerhalb der Kühldose 1 angeordnet.

Durch die Stützelemente 42 wird vorteilhafterweise die mechanische Stabilität der Kühldose 1 sichergestellt sowie ihre thermischen Eigenschaften in Bezug auf die Kühlung von elektrischen Bauelementen verbessert. Das ist deshalb der Fall, da die Y-förmigen Stützelemente 42 eine verbesserte Durchströmung der Kühldose 1 ermöglichen sowie eine vergrößerte Wärmeübertragungsfläche zwischen der Kühldose 1 und dem ihr durchströmenden Kühlfluid aufweisen. Zudem wird durch die insbesondere hohe Anzahl der Stützelemente 42 die mechanische Stabilität der Kühldose 1 verbessert, sodass nur geringe Anforderungen an die mechanische Stabilität der Halbschalen 21, 22 gestellt werden müssen. Dadurch können die Halbschalen 21, 22 beispielsweise als tiefgezogene Bleche ausgebildet sein, die miteinander verschweißt oder verlötet werden. Dadurch wird vorteilhafterweise ein kostengünstigeres Herstellungsverfahren der Kühldose 1 ermöglicht.

Weiterhin ist es durch eine Änderung der räumlichen Anordnung der Stützelemente 42 möglich die Kühldose 1 an ein weiteres Kühlfluid anzupassen. Somit kann das grundsätzliche Herstellungsverfahren der Kühldose 1 auch für verschiedene Kühlfluide beibehalten werden.

In Figur 2 ist die Kühldose 1 aus Figur 1 in einer seitlichen Darstellung (Seitendarstellung) gezeigt.

Hierbei zeigt Figur 2 im Wesentlichen die gleichen Elemente wie bereits Figur 1. Die Y-förmigen Stützelemente 42 erscheinen in der Seitendarstellung rechteckförmig. Eine Naht zwischen den zwei Halbschalen 21, 22, die sich beispielsweise durch ein Verschweißen oder ein Verlöten der beiden Halbschalen 21, 22 ausbildet, ist durch die gestrichelte Linie gekennzeichnet.

Das unter Figur 1 Gesagte kann unmittelbar und eindeutig auf die in Figur 2 gezeigte Kühldose 1 übertragen werden. Die erste und zweite Öffnung 61, 62 sind in der Seitenansicht versetzt zueinander angeordnet.

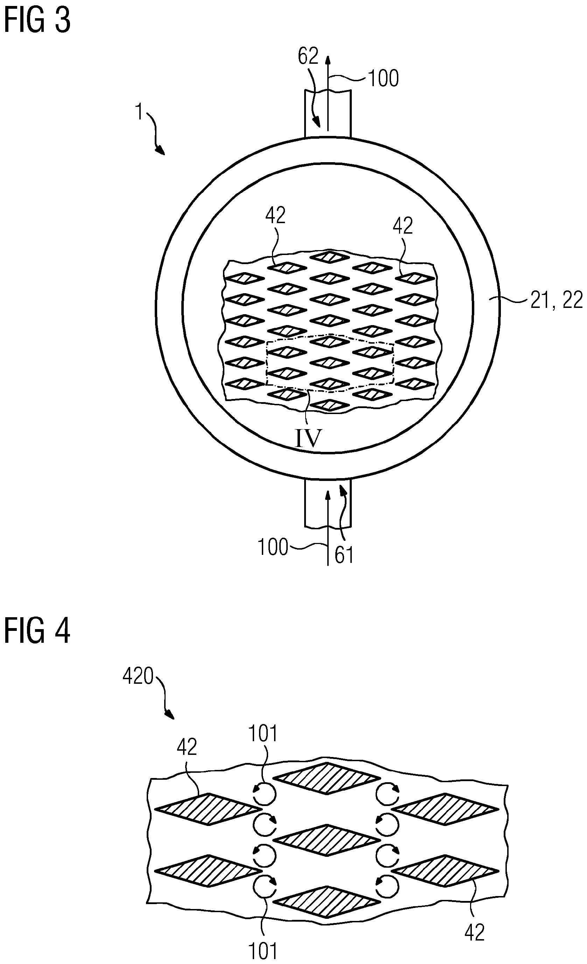

In Figur 3 ist eine weitere nicht zur Erfindung zugehörige Kühldose 1 dargestellt, die rautenförmige Stützelemente 42 aufweist. Mit anderen Worten weist die in Figur 3 dargestellte Kühldose 1 im Gegensatz zu der in Figur 1 oder 2 dargestellten Kühldose rautenförmige Stützelemente 42 auf. Wiederum ist ein sinnbildlicher Ausschnitt IV der rautenförmigen Stützelemente 42 dargestellt, der eine geöffnete Kühldose 1 andeutet.

In Figur 4 ist eine Vergrößerung 420 des genannten Ausschnittes IV dargestellt. Der vergrößerte Ausschnitt 420 zeigt sieben rautenförmige Stützelemente 42.

Weiterhin ist die Wirkung der rautenförmigen Stützelemente 42 auf eine Durchströmung des Kühlfluids vereinfacht dargestellt. Aufgrund der rautenförmigen Ausbildung der Stützelemente 42 kommt es zur Wirbelbildung und Wirbelablösung zwischen den rautenförmigen Stützelementen 42. Dies ist durch das Bezugszeichen 101 gekennzeichnet. Dadurch bildet sich vorteilhafterweise keine laminare, sondern eine turbulente Strömung beziehungsweise Durchströmung des Kühlfluids innerhalb der Kühldose 1 aus, wodurch die Wärmeübertragung zwischen der Kühldose 1 und dem Kühlfluid verbessert wird. Selbiges gilt für die Y-förmigen Stützelemente.

Weiterhin erhöhen die rautenförmigen Stützelemente 42, wie bereits die Y-förmigen Stützelemente in Figur 1 oder Figur 2, die mechanische Stabilität der in Figur 3 dargestellten weiteren Kühldose 1.

Die Erfindung stellt wenigstens eine Kühldose bereit, die einfach hergestellt werden kann, beispielsweise mittels tiefgezogener Bleche, wobei die mechanische Stabilität der Kühldose durch die erfindungsgemäß vorgesehenen Stützelemente sichergestellt wird, wobei die Stützelemente zugleich die thermischen Eigenschaften der Kühldose verbessern. Die mechanischen und thermischen Eigenschaften der Y-förmigen Stützelemente 42 wirken folglich synergetisch zusammen.

## Patentansprüche

1. Kühldose (1) zur Kühlung elektrischer Bauelemente mit zwei verbundenen Halbschalen (21, 22), wobei die Kühldose (1) eine Mehrzahl von Stützelementen (42) umfasst, wobei die Stützelemente (42) innerhalb eines zwischen den zwei Halbschalen ausgebildeten Volumens zur mechanischen Stützung der Halbschalen (21, 22) angeordnet sind, **dadurch gekennzeichnet, dass** die Stützelemente (42) Y-förmig ausgebildet sind.

2. Kühldose (1) gemäß Anspruch 1, **dadurch gekennzeichnet, dass** die Halbschalen (21, 22) als tiefgezogene Bleche ausgebildet sind.

3. Kühldose (1) gemäß einem der vorhergehenden Ansprüche, **dadurch gekennzeichnet, dass** die zwei Halbschalen (21, 22) wenigstens teilweise stoffschlüssig verbunden sind.

4. Kühldose (1) gemäß einem der vorhergehenden Ansprüche, **dadurch gekennzeichnet, dass** die Anordnung der Stützelemente (42) ein regelmäßiges Gitter ausbildet.

5. Kühldose (1) gemäß einem der vorhergehenden Ansprüche, **dadurch gekennzeichnet, dass** jedes Stützelement (42) wenigstens teilweise stoffschlüssig mit den zwei Halbschalen (21, 22) verbunden ist.

6. Kühldose (1) gemäß einem der vorhergehenden Ansprüche, **dadurch gekennzeichnet, dass** diese wenigstens zwei Öffnungen (61, 62) zum Einleiten und/oder Ausleiten eines Kühlfluids aufweist.

7. Kühlvorrichtung zur Kühlung elektrischer Bauelemente, **dadurch gekennzeichnet, dass** diese eine Mehrzahl von Kühldosen (1) gemäß einem der vorhergehenden Ansprüche aufweist, wobei die Kühldosen (1) gestapelt angeordnet sind.

8. Kühlvorrichtung gemäß Anspruch 7, **dadurch gekennzeichnet, dass** zwischen zwei benachbarten Kühldosen wenigstens ein zu kühlendes elektrisches Bauelement angeordnet ist.

9. Kühlvorrichtung gemäß Anspruch 8, **dadurch gekennzeichnet, dass** die gestapelten Kühldosen (1) zusammen mit dem wenigstens einen elektrischen Bauelement mechanisch gegeneinander verspannt sind.

10. Verfahren zur Herstellung einer Kühldose (1) gemäß einem der Ansprüche 1 bis 6, bei dem zwei Halbschalen (21, 22) zur Ausbildung eines Volumens wenigstens teilweise miteinander verbunden werden, bei dem vor oder nach dem Verbinden der zwei Halbschalen (21, 22) eine Mehrzahl von Stützelemente (42) zur mechanischen Stützung der zwei Halbschalen (21, 22) innerhalb eines Volumens zwischen den zwei Halbschalen (21, 22) angeordnet werden, **gekennzeichnet dadurch, dass** Y-förmige Stützelemente (42) verwendet werden.

11. Verfahren gemäß Anspruch 10, bei dem die zwei Halbschalen (21, 22) stoffschlüssig verbunden werden.

12. Verfahren gemäß Anspruch 10 oder 11, bei dem jedes Stützelement (42) wenigstens teilweise mit den zwei Halbschalen (21, 22) stoffschlüssig verbunden wird.

13. Verfahren gemäß einem der Ansprüche 10 bis 12, bei dem gesägte und/oder gefräste Stützelemente (42) verwendet werden.

## Claims

1. Cooling box (1) for cooling electrical components, having two connected half-shells (21, 22), wherein the cooling box (1) comprises a plurality of support elements (42), wherein the support elements (42) are arranged within a volume formed between the two half-shells for mechanical support of the half-shells (21, 22), **characterized in that** the support elements (42) are of Y-shaped form.

2. Cooling box (1) according to Claim 1, **characterized in that** the half-shells (21, 22) are in the form of deep-drawn metal sheets.

3. Cooling box (1) according to either of the preceding claims, **characterized in that** the two half-shells (21, 22) are at least partially connected in a materially bonded manner.

4. Cooling box (1) according to one of the preceding claims, **characterized in that** the arrangement of the support elements (42) forms a regular grid.

5. Cooling box (1) according to one of the preceding claims, **characterized in that** each support element (42) is at least partially connected in a materially bonded manner to the two half-shells (21, 22).

6. Cooling box (1) according to one of the preceding claims, **characterized in that** this has at least two openings (61, 62) for introduction and/or discharge of a cooling fluid.

7. Cooling device for cooling electrical components, **characterized in that** this has a plurality of cooling boxes (1) according to one of the preceding claims, wherein the cooling boxes (1) are arranged in a stacked manner.

8. Cooling device according to Claim 7, **characterized in that** at least one electrical component to be cooled is arranged between two adjacent cooling boxes.

9. Cooling device according to Claim 8, **characterized in that** the stacked cooling boxes (1), together with the at least one electrical component, are mechanically braced against one another.

10. Method for producing a cooling box (1) according to one of Claims 1 to 6, in which two half-shells (21, 22), for forming a volume, are at least partially connected to one another, in which, before or after the connection of the two half-shells (21, 22), a plurality of support elements (42) are arranged within a volume between the two half-shells (21, 22) for mechanical support of the two half-shells (21, 22), **characterized in that** Y-shaped support elements (42) are used.

11. Method according to Claim 10, in which the two half-shells (21, 22) are connected in a materially bonded manner.

12. Method according to Claim 10 or 11, in which each support element (42) is at least partially connected in a materially bonded manner to the two half-shells (21, 22).

13. Method according to one of Claims 10 to 12, in which sawn and/or milled support elements (42) are used.

## Revendications

1. Boîte (1) de refroidissement pour le refroidissement de composants électriques, comprenant deux hémicoquilles (21,22) reliées, la boîte (1) de refroidissement comprenant une pluralité d'éléments (42) d'appui, dans laquelle les éléments (42) d'appui sont pour l'appui mécanique des hémicoquilles (21, 22) disposés à l'intérieur d'un volume constitué entre les deux hémicoquilles, **caractérisée en ce que** les éléments (42) d'appui sont constitués en forme de Y.

2. Boîte (1) de refroidissement suivant la revendication 1, **caractérisée en ce que** les hémicoquilles (21, 22) sont constituées sous la forme de tôles ayant subi un emboutissage profond.

3. Boîte (1) de refroidissement suivant l'une des revendications précédentes, **caractérisée en ce que** les deux hémicoquilles (21, 22) sont reliées au moins en partie à coopération de matière.

4. Boîte (1) de refroidissement suivant l'une des revendications précédentes, **caractérisée en ce que** l'agencement des éléments (42) d'appui constitue un réseau régulier.

5. Boîte (1) de refroidissement suivant l'une des revendications précédentes, **caractérisée en ce que** chaque élément (42) d'appui est relié au moins en partie à coopération de matière aux deux hémicoquilles (21, 22).

6. Boîte (1) de refroidissement suivant l'une des revendications précédentes, **caractérisée en ce qu'**elle a au moins deux ouvertes (61, 62) pour l'entrée et/ou la sortie d'un fluide de refroidissement.

7. Dispositif de refroidissement pour le refroidissement de composants électriques, **caractérisé en ce qu'**il a une pluralité de boîtes (1) de refroidissement suivant l'une des revendications précédentes, les boîtes (1) de refroidissement étant empilées.

8. Dispositif de refroidissement suivant la revendication 7, **caractérisé en ce qu'**au moins un composant électrique à refroidir est disposé entre deux boîtes de refroidissement voisines.

9. Dispositif de refroidissement suivant la revendication 7, **caractérisé en ce que** les boîtes (1) de refroidissement empilées sont ensemble avec le au moins un composant électrique bloquées les unes par rapport aux autres mécaniquement.

10. Procédé de fabrication d'une boîte (1) de refroidissement suivant l'une des revendications 1 à 6, dans lequel on relie entre elles au moins en partie deux hémicoquilles (21, 22) pour former un volume, dans lequel avant ou après la liaison des deux hémicoquilles (21, 22), on met une pluralité d'éléments (42) d'appui pour l'appui mécanique des deux hémicoquilles (21, 22) dans un volume compris entre les deux hémicoquilles (21, 22), **caractérisé en ce qu'**on utilise des éléments (42) d'appui en forme de Y.

11. Procédé suivant la revendication 10, dans lequel on relie à coopération de matière les deux hémicoquilles (21, 22).

12. Procédé suivant la revendication 10 ou 11, dans lequel on relie à coopération de matière chaque élément (42) d'appui au moins en partie aux deux hémicoquilles (21, 22).

13. Procédé suivant l'une des revendications 10 à 12, dans lequel on utilise des éléments (42) d'appui sciés et/ou fraisés.
